# EUROPÄISCHE PATENTSCHRIFT

(11) **EP 1 217 664 B1**
(45) Veröffentlichungstag und Bekanntmachung des Hinweises auf die Patenterteilung: **03.03.2010**
(21) Anmeldenummer: 01129047.5
(22) Anmeldetag: 07.12.2001
(51) Int. Cl.: H01L 33/00, H01L 25/075, B64D 47/02

(54) **Halbleiter-Leuchteinheit und Verfahren zur Herstellung derselben**
Semiconductor lighting unit and method for producing the same
Unité d'éclairage à semiconducteur et procédé de fabrication

(30) Priorität: 21.12.2000 DE 10064422
(43) Veröffentlichungstag der Anmeldung: 26.06.2002
(73) Patentinhaber: Goodrich Lighting Systems GmbH, 59557 Lippstadt (DE)
(72) Erfinder: Hessling, Andre, Dipl.-Ing., 59555 Lippstadt (DE); Becker, Stefan, Dipl.-Ing., 59590 Geseke (DE); Schulz, Rico, Dipl.-Ing., 59555 Lippstadt (DE)
(74) Vertreter: Hilleringmann, Jochen

(56) Entgegenhaltungen:
- EP-A2- 1 033 525
- EP-A2- 1 059 202
- WO-A-97/50132
- DE-A1- 2 732 780
- DE-A1- 19 640 006
- DE-A1- 19 757 850
- DE-A1- 19 847 884
- DE-U1- 8 915 156
- DE-U1- 20 007 730
- JP-A- 11 121 473
- JP-A- 61 081 678
- JP-A- 2000 269 555

## Beschreibung

Die Erfindung betrifft eine Halbleiter-Leuchteinheit für optische Systeme in einem Fahrzeug, insbesondere in einem Flugzeug, mit einem Halbleiterbaustein, der auf einem Substrat montiert ist und elektrisch mit externen Anschlüssen verbunden ist.

Zur Beleuchtung in und an Fahrzeugen werden mittlerweile zunehmend Leuchtdioden eingesetzt. Solche Leuchtdioden (LED), wie sie beispielsweise aus der EP-A-0 974 485 bekannt sind, weisen einen Halbleiterbaustein auf, der auf einen Träger montiert und mit einem Kunststoff mit angesetzter Linse vergossen wird. Das so gebildete LED-Gehäuse wird dann mit abragenden Anschlussbeinchen auf einer Trägerplatte elektrisch kontaktiert, die innerhalb eines Leuchtengehäuses angeordnet ist. Das Leuchtengehäuse weist üblicherweise auf einer in Abstrahlrichtung orientierten Seite eine Lichtscheibe mit einer Linsenfunktion auf.

Nachteilig bei der bekannten Leuchteinheit ist, dass zur Erzeugung eines relativ großen Lichtstromes ein großer Bauraum erforderlich ist. Zwar sind Lumineszenzplatten bekannt, die nach Art eines Plattenkondensators zwischen einer transparenten und einer reflektierenden Metallelektrode eine Halbleiterschicht aufweisen, wobei die Halbleiterschicht durch Stoßionisation zur Lumineszenz angeregt werden kann. Solche Lumineszenzplatten finden Anwendung als großflächige homogene Lichtquellen und als Display-Elemente für Großanzeigen, siehe Lexikon Elektronik und Mikroelektronik, Dieter Sautter, Hans Weinerth, 2. Auflage, VDI-Verlag 1993, Seite 608.

Ferner ist aus DE-U-200 07 730 eine Halbleiterleuchteinheit nach dem Oberbegriff des Anspruchs 1 bekannt. Weitere Halbleiter-Leuchteinheiten sind in DE-A-27 32 780, EP-A-1 033 525, EP-A-1 059 202 und DE-U-89 15 156 beschrieben.

Aufgabe der vorliegenden Erfindung ist es, eine Halbleiter-Leuchteinheit und ein Verfahren zur Herstellung einer Halbleiter-Leuchteinheit anzugeben, so dass eine platzsparende und leistungsfähige Lichtquelle zur Verwendung im Fahrzeugbereich geschaffen wird, die die Abstrahlung von Licht mit einer ersten Farbe erlaubt, welches von abgestrahltem Licht einer zweiten Farbe umgeben ist.

Zur Lösung dieser Aufgabe wird mit der Erfindung eine Halbleiter-Leuchteinheit nach Anspruch 1 vorgeschlagen. Verschiedene Ausgestaltungen der Erfindung sind Gegenstand der jeweiligen Unteransprüche.

Ein Vorteil der Halbleiter-Leuchteinheit besteht darin, dass auf einfache Weise eine kompakte Leuchteinheit mit einer homogenen Lichtemission geschaffen ist. Das Substrat weist dabei eine Doppelfunktion auf. Zum einen dient das Substrat als Träger für eine oder mehrere Halbleiterbausteine. Zum anderen ist das Substrat als Leiterplatte ausgebildet mit mehreren Leiterbahnen, deren eine Enden mit Anschlüssen des Halbleiterbausteins und deren andere Enden mit externen Anschlüssen der Leiterplatte verbunden sind. Die externen Anschlüsse der Leiterplatte können beispielsweise als senkrecht von der Leiterplatte abragende Kontaktierungsstifte ausgebildet sein. Durch die mechanische und elektrische Funktion des Substrats kann eine Leuchteinheit mit geringer Bautiefe erzielt werden.

Nach einer besonderen Ausführungsform der Halbleiter-Leuchteinheit ist der Halbleiterbaustein als Chip ausgebildet, der mittels Drahtbonden mit korrespondierenden Enden der Leiterbahn verbunden ist. Vorteilhaft kann hierdurch eine große Anzahl von Halbleiterbausteinen auf einer vorgegebenen Substratfläche angeordnet und kontaktiert werden. Der Abstand benachbarter Halbleiterbausteine kann in einem Bereich von 0,3 mm bis 1 mm liegen. Hierdurch wird eine relativ hohe Packungsdichte erzielt, die zu einer homogenen Lichtemission führt. Mit zunehmender Lichtintensitätssteigerung der Halbleiterbausteine kann die Anzahl derselben verringert werden.

Nach der Erfindung der Halbleiter-Leuchteinheit ist der Halbleiterbaustein vollständig durch eine aushärtbare Vergussmasse abgedeckt. Die Vergussmasse dient als mechanischer Schutz für die Halbleiter-Leuchteinheit. Die Vergussmasse weist ein Konvertierungsmittel auf, mittels dessen das von den Halbleiterbausteinen emittierte Licht in weißes Licht konvertiert wird. Vorteilhaft dient somit die Vergussmasse nicht nur als mechanischer Schutz, sondern auch zur Verbesserung der optischen Eigenschaften der Halbleiter-Leuchteinheit.

Ferner ist nach der Erfindung auf dem Substrat eine Farbfilterumrandung aufgebracht, die als Begrenzungsring zum Aufbringen der Vergussmasse dient. Die Farbfilterumrandung dient zum einen zur Begrenzung beim Aufbringen der zähflüssigen Vergussmasse und zum anderen zum Generieren einer Randstrahlung in einer zusätzlichen Farbe.

Nach einer Weiterbildung der Halbleiter-Leuchteinheit ist das Substrat aus einem mehrschichtigen metallischen oder keramischen Material gebildet, das einen geringen thermischen Widerstand aufweist. Vorzugsweise besteht das Substrat aus einem thermisch hochleitenden Material, das für eine schnelle Ableitung der durch das oder die Halbleiterbausteine erzeugten Wärme sorgt. Das Substrat kann beispielsweise aus einem gewalzten Stahl bestehen.

Ein Ausführungsbeispiel der Erfindung wird nachfolgend anhand der Zeichnungen näher erläutert.

Es zeigen:

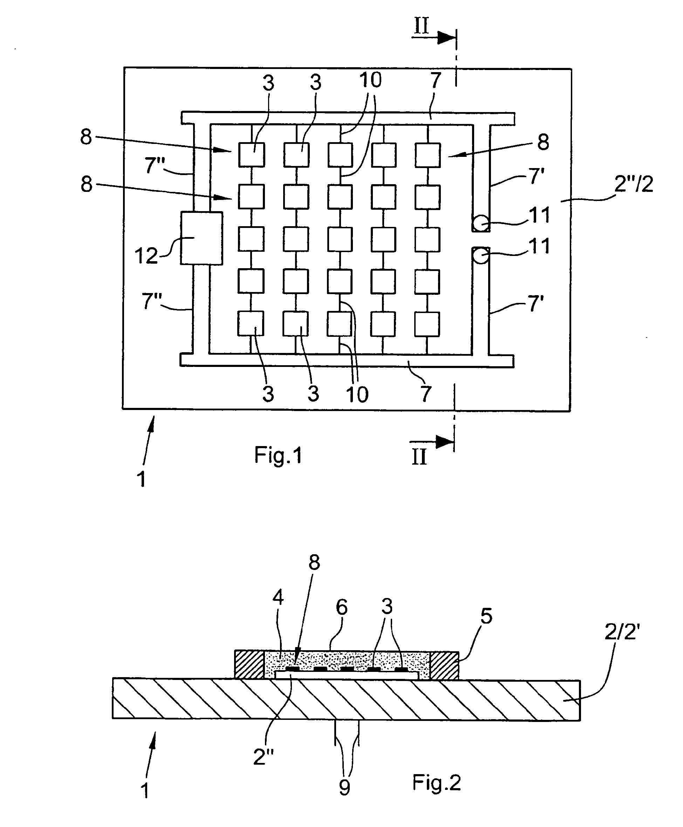

- Fig. 1: eine Teildraufsicht auf eine Halbleiter-Leuchteinheit und
- Fig. 2: einen Querschnitt durch die Halbleiter-Leuchteinheit entlang der Schnittlinie II-II in Fig. 1.

Eine Halbleiter-Leuchteinheit 1 besteht im Wesentlichen aus einem Substrat 2, auf dem eine Mehrzahl von lichtemittierenden Halbleiterbausteinen 3 angeordnet und durch eine Vergussmasse 4 vollständig abgedeckt sind.

Die Halbleiterbausteine 3 sind regelmäßig und in einem Abstand von 0,3 mm bis 1 mm zueinander auf einer Seite des Substrats 2 angeordnet. Die Vergussmasse 4 umfasst die Halbleiterbausteine 3 vollständig und wird durch eine starre Farbfilterumrandung 5 begrenzt, die sich von dem Substrat 2 erhebt. Die Farbfilterumrandung 5 bewirkt eine Änderung der von den Halbleiterbausteinen 3 emittierten Farbe des Lichtes.

Der Halbleiterbaustein 3 ist vorzugsweise als Chip ausgebildet, der über elektrische Anschlüsse verfügt. Der Chip wird derart auf das Substrat 2 aufgebracht und mit diesem klebend verbunden, dass die elektrischen Anschlüsse des Chips auf einer dem Substrat 2 abgewandten Seite angeordnet sind. Der Halbleiterbaustein 3 besteht aus einem für Leuchtdioden (LED) üblichen Halbleitermaterial, beispielsweise GaN oder SiC. Im vorliegenden Ausführungsbeispiel emittiert der Halbleiterbaustein 3 blaues Licht mit einer Wellenlänge von ca. 470 nm.

Dadurch, dass die Vergussmasse 4 ein Konvertierungsmittel 6, nämlich Phosphor, aufweist, wird das von den Halbleiterbausteinen 3 emittierte blaue Licht in weißes Licht konvertiert. Das Konvertierungsmittel 6 ist gleichmäßig in der aus Silikon bestehenden Vergussmasse 4 verteilt angeordnet. Die Vergussmasse 4 ermöglicht neben dem mechanischen Schutz der Halbleiterbausteine 3 und der lichttechnischen Beeinflussung auch einen ESD-Schutz, der für schnelle elektrostatische Entladung sorgt.

Das Substrat 2 besteht aus einem mehrschichtigen metallischen oder keramischen Material, vorzugsweise aus einem gewalzten Stahlmaterial 2' sowie aus einer Berylliumoxidschicht 2", auf der die Halbleiterbausteine 3 angeordnet sind. Zur Herstellung der Halbleiter-Leuchteinheit wird das Substrat 2 auf einer Seite mit einer Leiterbahnstruktur versehen. Die so gebildeten Leiterbahnen 7 können durch Aufätzen, Aufdampfen oder dergleichen aufgebracht werden. Nachfolgend werden die Halbleiterbausteine 3 in Anschlussbereichen 8 der so gebildeten Leiterplatte 2 aufgeklebt. Anschlüsse der Halbleiterbausteine 3 können dann mittels Drahtbonden über Golddrähte 10 elektrisch in Reihe geschaltet sein. Die randseitigen Halbleiterbausteine 3 sind über Golddrähte 10 mit Leiterbahnen 7 verbunden, die jeweils eine Leiterschiene bilden, an der mehrere Reihen von Halbleiterbausteinen 3 kontaktiert sind. Die Leiterbahnen 7 weisen Fortsätze 7' auf, die zu Durchkontaktierungen 11 führen. Die Durchkontaktierungen 11 schaffen eine Verbindung zu auf einer den Halbleiterbausteinen 3 abgewandten Seite des Substrats 2 angeordneten externen Anschlüssen 9. Die externen Anschlüsse 9 sind als Kontaktstifte ausgebildet, die mit entsprechenden Kontaktelementen einer nicht dargestellten elektrischen Baueinheit kontaktierbar sind.

Die Leiterbahnen weisen weitere Fortsätze 7" auf, die zu einer Ansteuerschaltung 12 für die Halbleiterbausteine 3 führen.

Nach erfolgter Kontaktierung der Halbleiterbausteine 3 an die entsprechenden Leiterbahnen 7 erfolgt durch Aufbringen der aushärtbaren Vergussmasse 4 eine vollständige Abdeckung des mit den Halbleiterbausteinen 3 versehenen Bereichs einer Hauptseite des Substrats 2.

Nach dem beschriebenen Ausführungsbeispiel ist das Substrat 2 mit fünfundzwanzig gitterartig angeordneten Halbleiterbausteinen 3 bestückt. Durch Verbesserung der Leistungsfähigkeit der Halbleiterbausteine 3 kann die Anzahl derselben verringert werden. Besonders einfach wird der Aufbau der Halbleiter-Leuchteinheit 1, wenn lediglich ein einziger Halbleiterbaustein 3 auf dem Substrat 2 angeordnet ist.

Die Halbleiter-Leuchteinheit 1 findet insbesondere Anwendung zur Innenraumbeleuchtung, vorzugsweise als Leseleuchte in Flugzeugen. Durch den flachen Aufbau der Halbleiter-Leuchteinheit 1 kann diese sinnvoll dort eingesetzt werden, wo wenig Bauraum zur Verfügung steht.

## Patentansprüche

1. Halbleiter-Leuchteinheit für optische Systeme in einem Fahrzeug, insbesondere in einem Flugzeug, mit
- einem Halbleiterbaustein (3), der auf einem Substrat (2) montiert ist und elektrisch mit externen Anschlüssen des Substrats (2) verbunden ist, wobei
- das Substrat (2) als eine mit strukturierten Leiterbahnen (7) versehene Leiterplatte (2) ausgebildet ist, wobei mindestens ein Anschluss des Halbleiterbausteins (3) an einen benachbarten Halbleiterbaustein (3) oder an einer Leiterbahn (7) elektrisch kontaktiert ist, und
- diese Leiterbahn (7) zu einem externen Anschluss (9) der Leiterplatte (2) führt, und
- einer Vergussmasse (4), die den Halbleiterbaustein (3) abdeckt und ein Konversionsmittel (6) zur Umsetzung der elektromagnetischen Strahlung der mindestens einen Leuchtdiode (3) in elektromagnetische Strahlung anderer Wellenlänge bzw. Wellenlängen umsetzt, wobei das Konversionsmittel (6) gleichmäßig in der Vergussmasse (4) verteilt gebunden ist und die von dem Halbleiterbaustein (3) emittierte Strahlung in weißes Licht umsetzt,
**dadurch gekennzeichnet,**
- **dass** die Vergussmasse (4) randseitig durch ein Farbfilterteil (5) begrenzt ist, das als eine starre vom Substrat aufragende Farbfilterumrandung (5) ausgebildet ist, die die durch die transparente Vergussmasse geführte, von dem Halbleiterbaustein (3) emittierte Strahlung in Licht einer zweiten Farbgebung umwandelt.

2. Halbleiter-Leuchteinheit nach Anspruch 1, **dadurch gekennzeichnet, dass** der Halbleiterbaustein (3) als Chip ausgebildet ist, dessen Anschlüsse mittels Bonddrähten mit den Leiterbahnen (7) elektrisch verbunden sind.

3. Halbleiter-Leuchteinheit nach einem der Ansprüche 1 und 2, **dadurch gekennzeichnet, dass** auf der Leiterplatte (2) eine Mehrzahl von in regelmäßigen Abständen zueinander angeordneten Halbleiterbausteinen (3) aufgebracht sind.

4. Halbleiter-Leuchteinheit nach einem der Ansprüche 1 bis 3, **dadurch gekennzeichnet, dass** die Abstände der benachbarten Halbleiterbausteine (3) in einem Bereich von 0,3 mm bis 1 mm liegen.

5. Halbleiter-Leuchteinheit nach einem der Ansprüche 1 bis 4, **dadurch gekennzeichnet, dass** das Substrat (2) aus einem mehrschichtigen metallischen oder keramischen Material besteht.

## Claims

1. A semiconductor light unit for use with vehicle optical systems, especially in aircraft, comprising:
- a semiconductor component (3) mounted on a substrate (2) and electrically connected to external connections of the substrate (2), wherein
- the substrate (2) is a printed circuit board (2) with structured printed conductors (7), whereby at least one connection of the semiconductor component (3) is in electric contact with at least one adjacent semiconductor component (3) or a printed conductor (7), and
- this printed conductor (7) leads to an external connection (9) of the printed circuit board (2), and
- a casting compound (4) that covers the semiconductor component (3) and a conversion agent (6) for the conversion of the electromagnetic radiation of the at least one light emitting diode (3) to electromagnetic radiation of another wavelength or wavelengths, said conversion agent (6) being evenly dispersed and bonded in the casting compound (4) and converting radiation emitted by the semiconductor component (3) to white light,
**characterized in that**
- the casting compound (4) is delimited at the border by a color segment (5) formed as a rigid color filter border (5) projecting from the substrate, said border converting radiation emitted by the semiconductor component (3) and guided through the transparent casting compound to light of a second color.

2. The semiconductor light unit of claim 1, **characterized in that** the semiconductor component (3) is in the form of a chip whose connections are electrically connected to the printed conductors (7) by means of wire bonds.

3. The semiconductor light unit of one of claims 1 and 2, **characterized in that** a plurality of equidistantly arranged semiconductor components (3) is applied onto the printed circuit board (2).

4. The semiconductor light unit of one of claims 1 to 3, **characterized in that** the distances between adjacent semiconductor components (3) are in a range between 0.3 mm to 1 mm.

5. The semiconductor light unit of one of claims 1 to 4, **characterized in that** the substrate (2) is made from a multi-layered metal or ceramic material.

## Revendications

1. Unité d'éclairage à semiconducteur pour des systèmes optiques de véhicules, notamment dans un avion, comprenant:
- un composant semiconducteur (3) monté sur un substrat (2) et connecté électriquement à des bornes externes du substrat (2),
- le substrat (2) étant réalisé en forme d'une platine (2) munie de pistes conductrices (7) structurées, au moins une borne du composant semiconducteur (3) étant en contact électrique avec an composant semiconducteur adjacent (3) ou une piste conductrice (7), et
- cette piste conductrice (7) menant à une borne externe (9) de la platine (2), et
- une masse de scellement (4) couvrant le composant semiconducteur (3), et un agent convertisseur (6) pour la conversion de la radiation électromagnétique de la au moins une diode émettrice de lumière (3) en radiation électromagnétique d'une autre longueur d'onde ou d'autres longueurs d'onde, l'agent convertisseur (6) étant dispersé uniformément et lié dans la masse de scellement (4) et convertissant la radiation émise par le composant semiconducteur (3) en lumière blanche,
**caractérisée en ce que**
- la masse de scellement (4) est limitée à ses bords par un élément de filtre de couleur (5) en forme d'un cadre de filtre de couleur (5) rigide en saillie du substrat, convertissant la radiation émise par le composant semiconducteur (3) et guidée à travers la masse de scellement transparente, en lumière d'une deuxième couleur.

2. Unité d'éclairage à semiconducteur selon la revendication 1, **caractérisée en ce que** le composant semiconducteur (3) est en forme d'une puce dont les bornes son connectées électriquement aux pistes conductrices (7) par des fils de soudage.

3. Unité d'éclairage à semiconducteur selon l'une quelconque des revendications 1 et 2, **caractérisée en ce que** plusieurs de composants semiconducteurs (3) sont prévus à distance régulière entre eux sur la platine (2).

4. Unité d'éclairage à semiconducteur selon l'une quelconque des revendications 1 à 3, **caractérisée en ce que** les distances entre des composants semiconducteurs (3) sont situées dans une gamme de 0.3 mm à 1mm.

5. Unité d'éclairage à semiconducteur selon l'une quelconque des revendications 1 à 4, **caractérisée en ce que** le substrat (2) est formé d'un matériau multicouche métallique ou céramique.
